# EUROPÄISCHE PATENTSCHRIFT

(11) **EP 3 778 088 B1**
(45) Veröffentlichungstag und Bekanntmachung des Hinweises auf die Patenterteilung: **25.12.2024**
(21) Anmeldenummer: 20189804.6
(22) Anmeldetag: 06.08.2020
(51) Int. Cl.: B23K 1/015, B04B 1/08, B04B 15/02

(54) **REFLOW-KONDENSATIONSLÖTANLAGE**
REFLOW CONDENSATION SOLDERING SYSTEM
INSTALLATION DE SOUDAGE PAR REFUSION PAR CONDENSATION

(30) Priorität: 14.08.2019 DE 102019212161
(43) Veröffentlichungstag der Anmeldung: 17.02.2021
(73) Patentinhaber: Rehm Thermal Systems GmbH, 89143 Blaubeuren-Seissen (DE)
(72) Erfinder: WILD, Paul, 89143 Blaubeuren-Seissen (DE); KRAUSS, Karin, 89143 Blaubeuren-Seissen (DE)
(74) Vertreter: Grünecker Patent- und Rechtsanwälte PartG mbB

(56) Entgegenhaltungen:
- EP-B2- 1 157 771
- DE-U1- 20 306 448
- JP-A- H01 178 578
- JP-A- H07 214 296

## Beschreibung

### Gebiet der Erfindung

Die vorliegende Erfindung betrifft eine Reflow-Kondensationslötanlage, wie zum Beispiel aus der EP 1157771 B2 bekannt. Weiterhin betrifft die vorliegende Erfindung ein Verfahren zum Betrieb der Reflow-Kondensationslötanlage.

### Stand der Technik

Bekanntermaßen wird beim Kondensationslöten, das auch als Dampfphasenlöten bezeichnet wird, beim Kondensieren einer gesättigten Dampfphase auf der Oberfläche eines zu verlötenden Bauteiles Energie in Form von Wärme frei, wodurch das Lot zum Schmelzen gebracht und somit die Verbindung des Bauteils zur Leiterbahn hergestellt wird. Die gesättigte Dampfphase wird durch eine siedende Wärmeübertragungsflüssigkeit erzeugt, wobei durch den Siedepunkt der Wärmeübertragungsflüssigkeit die Prozesstemperatur beim Lötvorgang vorgegeben ist. Vorzugsweise wird als Flüssigkeit zur Wärmeübertragung in der Regel Perfluorpolyether (PFPE), eine Gruppe von bei Raumtemperatur üblicherweise flüssigen bis pastösen Kunststoffen, verwendet. Insbesondere wird beim Dampfphasenlöten ein Perfluorpolyether mit einem Siedepunkt von z.B. 260°C verwendet, der auch als Galden HS260 (HS260 = 260 °C Siedepunkt) bezeichnet wird. Während des Reflowlötens wird das Galden mit den Kondensaten und anderen Abprodukten (insgesamt als Residuen bezeichnet) beladen und bildet mit ihnen eine Emulsion. Um Kosten zu sparen und Umwelt zu schonen wird diese Emulsion wieder recycelt, d.h. das Galden wird von den Residuen getrennt, so dass das Galden wieder einem Lötprozess zugeführt werden kann.

Bei Anlagen des Standes der Technik findet sich das Wärmeübertragungsmedium nicht in einem geschlossenen Kreislauf, sondern kondensiert im selben Behälter, in dem der Dampf durch Erhitzen hergestellt wird. Eine solche Anlage wird in der Publikationsschrift der französischen Patentanmeldung FR2499228 beispielhaft beschrieben. Solche Anlagen umfassen mindestens eine Prozesskammer, die teilweise mit dem PFPE gefüllt ist. Heizwiderstände heizen das PFPE bis zum Siedepunkt auf. Der heiße PFPE Dampf kondensiert auf der zu lötenden Baugruppe und erwärmt die Baugruppe bis zum Schmelzpunkt des auf der Baugruppe aufgetragenen Lots. Danach wird die Baugruppe abgekühlt und aus der Prozesskammer entfernt, sodass ein neuer Lötvorgang mit einer neuen zu lötenden Baugruppe starten kann. Nach einer Reihe von Lötvorgängen wird das PFPE gereinigt. Die Säuberung des PFPE findet nicht kontinuierlich, sondern in längeren Wartungszyklen statt. Der Abstand zwischen den jeweiligen

Reinigungen muss mit der Erhöhung des Durchsatzes verringert werden. Gleichzeitig steht gegen Ende des Wartungszyklus weniger reines PFPE für den Prozess zur Verfügung und gleichzeitig kann sich am Boden des Behälters bitumen- bzw. teerartige Residuen sammeln, deren Entfernung ebenfalls sehr aufwendig ist.

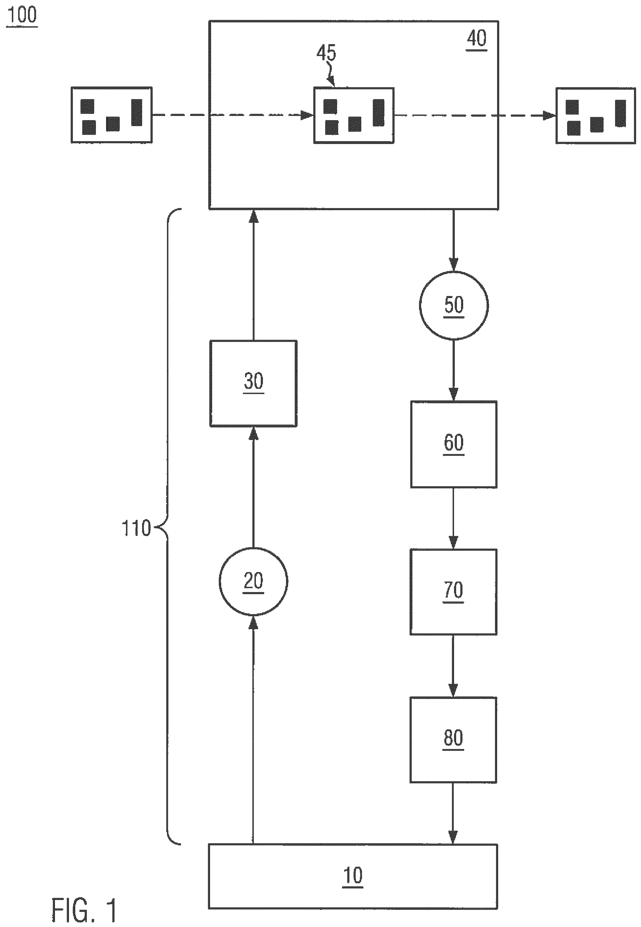

Um die Verunreinigungen in der Prozesskammer klein zu halten, wird in den moderneren Anlagen wie beispielsweise aus der Condenso Reihe von REHM Thermal Systems GmbH das PFPE in einem Kreislauf gehalten. Figur 1 zeigt schematisch einige wesentlichen Komponenten einer Reflow-Kondensationslötanlage 100 mit einem Kreislaufsystem für ein Wärmeübertragungsmedium, wie sie in den Anlagen der Condenso Reihe von REHM Thermal Systems GmbH verwendet werden. Figur 1 zeigt eine Pumpe 20, die das flüssige PFPE aus einem Reservoir 10 zu einer Heizeinrichtung 30 transportiert. In der Heizeinrichtung 30 wird das PFPE verdampft und anschließend einer Prozesskammer 40 zugeführt. Anschließend kondensiert das Medium (dampfförmiges PFPE) und erhitzt so die zu lötenden Bauteile auf einer Leiterplatte 45 in der Prozesskammer 40. Durch den Siedepunkt des PFPE ist gleichzeitig die maximale Löttemperatur erreicht. In einer anschließenden Regenerationsphase (Trennphase) für das PFPE wird das Wärmeübertragungsmedium (sowohl Anteile in dampfförmigen als auch in flüssigem Aggregatszustand) mit einer Pumpe 50 aus der Kammer 40 abgesaugt. Nach der Absaugung wird der Anteil des Wärmeübertragungsmediums im dampfförmigen Aggregatszustand in einem Kondensator 60 kondensiert. Das Ergebnis ist eine Emulsion aus Verunreinigungen und der ursprünglichen Flüssigkeit, da die beim Lötprozess verwendeten Flussmittel und Lötpasten, sowie Verunreinigungen, die durch die Leiterplatte 45 in die Prozesskammer 40 kommen, zusammen mit dem Wärmeübertragungsmedium abgesaugt werden. Die Emulsion wird in einem Auffangbehälter 70 gesammelt, wo eine erste Sedimentation des PFPE aufgrund dessen hoher Dichte (ρ = 1.83 g/cm³) stattfindet. Anschließend findet eine weitere Reinigungsstufe über einen Filterkasten 80 statt, bevor das gefilterte und gereinigte PFPE im Vorratsbehälter 10 gesammelt wird, von wo aus es erneut in die Prozesskammer 40 eingespritzt wird. Als Filter werden konventionell Filtermatten, Granulatfilter und/oder Aktivkohlefilter verwendet. Partikelabscheidung mit Venturi Düsen erwies sich als unbrauchbar.

Eine zur Figur 1 ähnlichen Anlage wird beispielhaft in der Europäischen Patentschrift EP 1157771 B2 beschrieben. Im Gegensatz zu Fig. 1 wird in der EP 1157771 B2 beschriebenen Anlage nur das Kondensat aus der Prozesskammer abgelassen und gefiltert, wodurch die in der EP 1157771 B2 beschriebenen Anlage zwar einfacher als in Figur 1 gezeigt aufgebaut sein kann, aber öfter gereinigt bzw. gewartet werden muss.

Eine Erhöhung des Durchsatzes führt zu einer geringeren Verweilzeit im Auffangbehälter. Das wiederum bedeutet, dass die Sedimentation des PFPE weniger vollständig stattfindet und es zu einer stärkeren Verschleppung der Verunreinigungen kommt und eine vollständige Reinigung und Filterung des Wärmeübertragungsmediums kann nicht mehr gewährleistet werden.

Es ist deshalb eine Aufgabe der vorliegenden Erfindung, die Reinigungsleistung im Kreislauf zu verbessern.

Die japanische Patentanmeldung JP H01 178578 A betrifft eine Ausrüstung zum Reinigen einer inerten Fluorkohlenstoff Flüssigkeit.

### Zusammenfassung

Um diese Aufgabe zu erfüllen, wird eine Reflow-Kondensationslötanlage gemäß Anspruch 1 bereitgestellt. Die beanspruchte Reflow-Kondensationslötanlage ist mit einem Kreislaufsystem eines Wärmeübertragungsmediums ausgestattet, wobei das Kreislaufsystem eine Zentrifuge und eine Kondensationseinrichtung für das Wärmeübertragungsmedium umfasst. Durch das Kreislaufsystem werden die Verunreinigungen nach jedem Lötvorgang für beispielsweise eine Leiterplatte abgepumpt, so dass für den Lötvorgang der nächsten Leiterplatte sauberes Wärmeübertragungsmedium zur Verfügung steht. Weiterhin kann durch die Kondensationseinrichtung für das Wärmeübertragungsmedium in Kombination mit der Zentrifuge das Wärmeübertragungsmedium eines Prozessdurchgangs effizient, d. h. wirksam mit einer hohen Trennrate, fast vollständig zur Wiederverwendung zurückgewonnen werden. Insbesondere bei der Verwendung von relativ teurem Galden als Wärmeübertragungsmedium ergeben sich dadurch Kostenvorteile. Zudem wird weniger Chemieabfall erzeugt und die Umwelt geschont.

In einer besonderen Ausführungsform ist die Zentrifuge ein Tellerseparator, eine spezielle Zentrifugenart. Tellerzentrifugen oder Tellerseparatoren eignen sich besonders gut zur Trennung von Suspensionen mit einer oder mehreren Flüssigphasen und mit kleinen Partikeln. Durch die Teller wird die Oberfläche, auf denen sich die verschiedenen Phasen absetzen können, vergrößert, wodurch der Trennvorgang erheblich beschleunigt werden kann. Im Folgenden wird die Erfindung anhand von Tellerseparatoren erklärt. Man sollte jedoch wissen, dass die vorliegende Erfindung allgemein mit Zentrifugen durchgeführt werden kann, und die Verwendung von Tellerseparatoren die Trennung effizienter macht.

Gemäß verschiedener Ausführungsformen kann die Anzahl der Teller, der Tellerabstand, die Drehungsgeschwindigkeit und das Volumen des Tellerseparators so ausgelegt sein, dass ein gewünschter Anlagendurchsatz erreicht wird, wobei zu erwartende Partikelgrößen von Verunreinigungen des Wärmeübertragungsmediums und Viskosität des verunreinigten Wärmeübertragungsmediums berücksichtigt werden.

Anzahl, Form, Aufbau und Anordnung der Teller sind in weiten Grenzen variabel und können auf die zu separierenden Stoffe der Suspension abgestimmt werden. Beispielsweise beeinflusst die Telleranzahl und die Drehgeschwindigkeit die Separationsgeschwindigkeit. Beispielsweise kann in bestimmten Ausführungsformen der Tellerseparator 4 bis 250 Teller aufweisen. Vorzugsweise weist der Tellerseparator bei Anwendungen in Kondensationsanlagen mindestens 250 Teller auf, wobei der Tellerabstand im Bereich von 0,2 mm - 14 mm liegt, und wobei die Teller gleich beabstandet sind. Bei stark unterschiedlichen Partikelgrößen kann es auch von Vorteil sein, dass der Tellerabstand im Zulaufbereich kleiner oder größer als am, dem Zulaufbereich gegenüberliegenden, Ende des Tellerstapels ist. Die Verteilung der Abstände im Tellerstapel kann dabei auch von unterschiedlichen Dichten von Verunreinigungspartikeln bestimmter Größe abhängen. Weiterhin kann der Tellerseparator ausgelegt sein, 1 - 150.000 Umdrehungen pro Minute auszuführen, vorzugsweise 1000 bis 10.000 Umdrehungen pro Minute. Der Tellerseparator kann ausgelegt sein, 2 - 6 Liter kondensiertes, verbrauchtes Wärmeübertragungsmedium zu verarbeiten, was einer Anlagengröße mit einer Füllmenge von 20 - 40 Liter entspricht.

Die Anzahl der Teller, das Volumen des Tellerseparators, die Tellerabstände und die Drehgeschwindigkeit wird auf den Anlagendurchsatz ausgelegt. Sollen beispielsweise 10 Reflowprozesse pro Stunde stattfinden, muss die Anlage so dimensioniert werden, dass pro Stunde das verbrauchte Wärmeübertragungsmedium 10-mal gereinigt werden kann.

In einer Ausführungsform ist die Kondensationseinrichtung für das Wärmeübertragungsmedium in dem Tellerseparator integriert. Durch die Integration dieser beiden Komponenten wird die Trennung des PFPEs von den Verunreinigungen beschleunigt. Der Separator erfüllt dabei eine doppelte Funktion: dampfförmiges Wärmeübertragungsmedium kondensiert und im Kondensat enthaltene Verunreinigungen werden separiert/getrennt. Da die Verunreinigungen und das Wärmeübertragungsmedium unterschiedliche Kondensationspunkte aufweisen erfolgt bereits bei der Kondensation eine Trennung der Komponenten, die durch die Rotation des Tellerseparators erhalten bleibt und verstärkt wird. Dadurch wird die Separation beschleunigt und das regenerierte Wärmeübertragungsmedium kann schneller und ggf. mit einem höheren Reinheitsgrad wieder einem Lötprozess zur Verfügung gestellt werden. D. h. eine Erhöhung des Anlagendurchsatzes wird ermöglicht.

Eine Integration der Kondensationseinrichtung in den Separator kann beispielsweise durch eine Einrichtung zur Begrenzung der Temperatur einer oder mehrerer Komponenten des Tellerseparators erreicht werden. Ein Tellerseparator kann beispielsweise folgende Komponenten umfassen: einen Einlass, einen Schwimmer, einen oder mehrere Teller und eine Trommel, die die drehbaren Teller aufnimmt. Dabei kann die Einrichtung zur Begrenzung der Temperatur eine aktive oder passive Kühlung der einen oder mehreren Komponenten des Tellerseparators umfassen.

In einer Ausführungsform ist die Einrichtung zur Begrenzung der Temperatur eine aktive Kühlung, bei der beispielsweise eine Wand einer oder mehrerer Komponenten mindestens einen Hohlraum aufweist, durch den ein Kühlfluid strömen kann.

In einer alternativen Ausführungsform ist die Einrichtung zur Begrenzung der Temperatur eine aktive Kühlung, wobei in eine Wand der einen oder mehreren Komponenten eine Heatpipe integriert ist. Gegenüber der vorher genannten Kühlung mit einem Kühlfluid hat eine Heatpipe den Vorteil, dass kein Kühlkreislauf mit Kühlfluid bereitgestellt werden muss.

In einer weiteren Ausführungsform ist die Einrichtung zur Begrenzung der Temperatur eine passive Kühlung, wobei mindestens eine Komponente der einen oder mehreren Komponenten so ausgestaltet ist, dass eine Wärmekapazität der mindestens einen Komponente ausreicht, eine Wärmemenge des vorbeiströmenden dampfförmigen Wärmeübertragungsmediums während einer vorbestimmten Trennphase aufzunehmen, so dass das Wärmeübertragungsmedium kondensiert. Die Materialien, die Dimensionen (Größe, Abmessungen, Masse) und die Strömungsgeometrien dieser Komponenten werden dabei so gewählt, dass die Wärmemenge, die bei der Kondensation des gesamten, in der Prozesskammer vorhandenen, dampfförmigen Wärmeübertragungsmediums frei wird, von der/den Komponente(n) aufgenommen werden kann. Möglich ist auch eine Kombination mit einer Prozesssteuerung, die das Timing für die Lötphasen und Regenerationsphasen (Trennphasen), die Flussrate des Wärmeübertragungsmediums durch den Separator und die Abkühlzeiten für die Separator Komponenten, so anpasst, dass nahezu das gesamte dampfförmige Wärmeübertragungsmedium in der Prozesskammer kondensieren kann und gleichzeitig die von den Separator Komponenten aufgenommene Wärme wieder abgegeben werden kann. Bei einer passiven Kühlung sind keine zusätzlichen Komponenten zur Kühlung nötig, sodass der Tellerseparator weniger Komponenten aufweist, die einfacher zu warten sind.

Eine passive Kühlung wird durch die Tatsache begünstigt, dass Lötphase und Regenerationsphase (des Wärmeübertragungsmediums) nacheinander ausgeführt wird. Da während der Lötphase kein dampfförmiges Wärmeübertragungsmedium in die Kondensationseinrichtung zugeführt wird, kann während dieser Zeit (Lötphase) die Kondensationseinrichtung bzw. die separierende Kondensatfalle abkühlen. D.h. Dampf wird nur nach dem Ende der Lötphase (in der Prozesskammer) zugeführt. Während des Lötprozesses (in der Prozesskammer) wird dem Tellerseparator kein Dampf zugeführt, so dass die Komponenten, an denen die Kondensation stattfindet abkühlen können (Abkühlphase der separierenden Kondensatfalle). Der Tellerseparator kann auch kontinuierlich weiterlaufen, selbst in der Abkühlphase, wenn kein Dampf zugeführt wird. In diesem Fall kann während der Abkühlphase das zuvor separierte PFPE erneut zugeführt werden. Damit werden drei Vorteile erreicht. Zum einen wird mit dem flüssigen PFPE der Tellerseparator gekühlt. Zum anderen wird der Reinheitsgrad des PFPE verbessert. Außerdem wird verhindert, dass der Tellerseparator trocken läuft. D.h. da die hydrodynamischen Bedingungen für das Separieren nur im gefüllten Zustand des Tellerseparators optimal sind, läuft der Tellerseparator im gefüllten Zustand am effizientesten.

Entsprechend weist in einer weiteren Ausführungsform das Kreislaufsystem für das Wärmeübertragungsmedium der Reflow-Kondensationslötanlage weiterhin eine Einrichtung auf, mit der gereinigtes PFPE der Zentrifuge während einer Abkühlphase der passiven Kühlung zugeführt werden kann.

In einer weiteren Ausführungsform hat das Wärmeübertragungsmedium einen Siedepunkt von 260°C. Da handelsübliche Lote einen Schmelzpunkt von weniger als 260 °C aufweisen, lassen sich handelsübliche Lote verwenden, ohne dass die zu lötenden Bauteile überhitzt werden.

Vorzugsweise wird als Wärmeübertragungsmedium Galden verwendet. Galden ist der handelsübliche Name für das Wärmeübertragungsmedium "Perfluorpolyether", das eine Reihe von vorteilhaften Eigenschaften beim Reflow-Kondensationslöten aufweist. Unter anderem weist Galden eine hohe Temperaturbeständigkeit, eine hohe Beständigkeit gegen reaktive Chemikalien, einen niedrigen Dampfdruck, keinen Flammpunkt, exzellente Wärmeübertragungseigenschaften, gute Benetzungseigenschaften und keinerlei chemische Aktivität auf. Galden ist nicht schädlich für die Ozonschicht in der Atmosphäre und ist kein Gefahrstoff im Sinne des Arbeitsschutzes.

Die oben genannte Aufgabe wird auch erfüllt durch ein Verfahren zum Betreiben der vorher genannten Reflow-Kondensationslötanlage. Das Verfahren umfasst das Einspritzen von dampfförmigen Perfluorpolyether in eine hermetisch dichte Prozesskammer mit einer zu lötenden Baugruppe, das Erwärmen der Baugruppe durch Kondensieren des dampfförmigen Perfluorpolyethers, das Absaugen von kondensiertem und dampfförmigem Perfluorpolyether einschließlich Verunreinigungen, Zuführen des abgesaugten Materials einer separierenden Kondensatfalle, die die Zentrifuge bzw. den Tellerseparator und die Einrichtung zum Kondensieren des Perfluorpolyethers umfasst, Kondensieren und Trennen des Perfluorpolyethers von den Verunreinigungen, und Verwenden des gereinigten Perfluorpolyethers für einen Lötvorgang für eine nachfolgende Baugruppe.

Gemäß verschiedenen Ausführungsformen kann der Tellerseparator intermittierend oder kontinuierlich betrieben werden. Da während der Lötphase, bei der in der Prozesskammer der Lötvorgang durchgeführt wird, keine Reinigung (Trennung/Regeneration) des Perfluorpolyethers stattfindet, kann der Tellerseparator in einen Ruhezustand versetzt, um Getriebe, Motor etc. zu schonen. In diesem Fall kann der Tellerseparator nach dem Ende der Ruhephase mit gereinigtem oder frischem Perfluorpolyether vorbefüllt werden, vorzugsweise mit 0,5 - 3 Liter Perfluorpolyether, und besonders bevorzugt mit 0,9 - 1,1 Liter Perfluorpolyether. Da optimale Trennbedingungen nur im gefüllten Zustand erreicht werden, wird der Tellerseparator auf diese Weise vorkonditioniert und der Reinigungsprozess wird effizienter.

Liegt der Anlagenschwerpunkt auf Optimierung des Durchsatzes oder Optimierung der Reinigungsleistung kann der Tellerseparator auch kontinuierlich betrieben werden. Zur Optimierung der Reinigungsleistung kann beispielsweise dem Tellerseparator während einer Lötphase gereinigtes Perfluorpolyether zugeführt werden. Zur Optimierung des Durchsatzes kann beispielsweise Dampf aus einer zweiten Prozesskammer, die zur ersten Prozesskammer zeitlich versetzt arbeitet, zugeführt werden. Bei entsprechender Dimensionierung des Tellerseparators kann auch Dampf aus mehr als zwei Prozesskammern, beispielsweise drei, vier oder fünf Prozesskammern, die den Lötprozess zeitlich zueinander versetzt durchführen, in einem kontinuierlich laufenden Tellerseparator verarbeitet werden.

### Beschreibung der Figuren

Die vorliegende Erfindung wird nun anhand der folgenden Figuren beschrieben, in denen
Fig. 1 eine Reflow-Kondensationslötanlage mit einem Kreislaufsystem eines Wärmeübertragungsmediums gemäß dem Stand der Technik zeigt,
Fig. 2 eine Reflow-Kondensationslötanlage mit einem Kreislaufsystem eines Wärmeübertragungsmediums gemäß einer Ausführungsform der vorliegenden Erfindung zeigt, und
Fig. 3 schematisch einen Tellerseparator mit integrierter Kondensationseinrichtung gemäß einer Ausführungsform der vorliegenden Erfindung zeigt.

### Ausführliche Beschreibung von bevorzugten Ausführungsformen

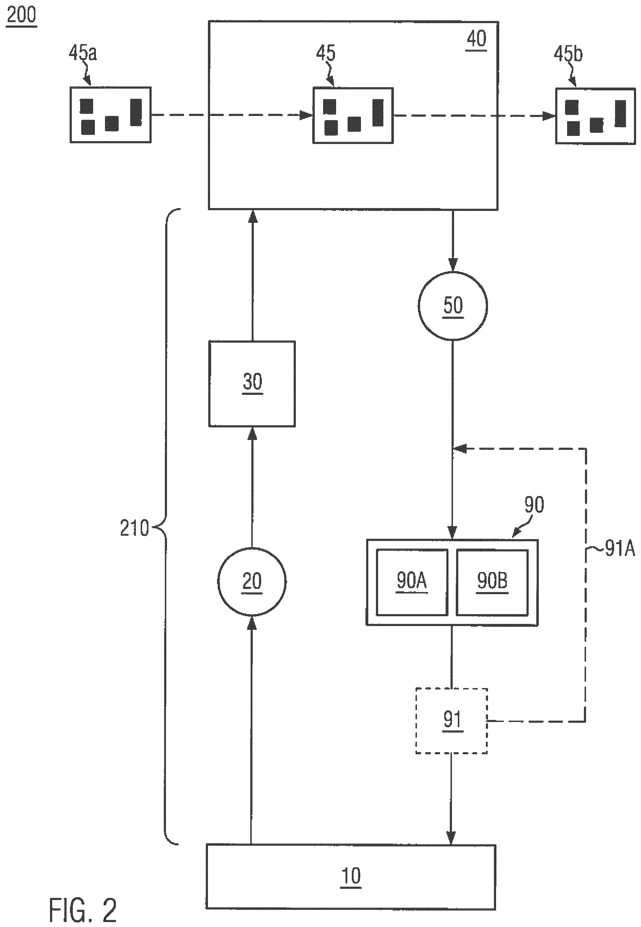

Fig. 2 zeigt eine Reflow-Kondensationslötanlage 200 mit einem Kreislaufsystem 210 für ein Wärmeübertragungsmedium gemäß einer Ausführungsform der vorliegenden Erfindung. Das Kreislaufsystem umfasst ein Reservoir 10, eine erste Pumpe 20, eine Heizeinrichtung 30, eine Prozesskammer 40, eine zweite Pumpe 50 und eine separierende Kondensatfalle 90.

Die erste Pumpe 20 pumpt flüssiges Wärmeübertragungsmedium in Form von Perfluorpolyether (PFPE) aus dem Reservoir 10 zur Heizeinrichtung 30. In der Heizeinrichtung 30 wird das PFPE verdampft und anschließend der Prozesskammer 40 zugeführt. Anschließend kondensiert das Medium (dampfförmiges PFPE) an der zu lötenden Leiterplatte 45 und erhitzt so die zu lötenden Bauteile auf der Leiterplatte 45 in der Prozesskammer 40 und die Lötpaste. Das PFPE wird so ausgelegt, dass der Siedepunkt des PFPE etwas höher als der Schmelzpunkt des Lots ist. Damit wird gewährleistet, dass gleichzeitig die Löttemperatur erreicht wird und die Bauteile während dem Löten nicht überhitzen, da die Siedetemperatur des PFPE gleichzeitig die Maximaltemperatur ist. Nach dieser "Lötphase" werden in einer ersten Phase einer "Regenerationsphase" oder "Trennphase" sowohl die Anteile des Wärmeübertragungsmediums im dampfförmigen als auch im flüssigen Aggregatszustand mit einer zweiten Pumpe 50 aus der Kammer 40 abgesaugt. Nach der Absaugung erfolgt in der separierenden Kondensatfalle 90 eine Kondensation des dampfförmigen Anteils des Wärmeübertragungsmediums und eine Trennung des Wärmeübertragungsmediums von den Residuen (Verunreinigungen). Entsprechend umfasst die separierende Kondensatfalle 90 eine Kondensationseinrichtung 90A und einen Separator 90B. Während dieser "Regenerationsphase" wird auch die Leiterplatte 45 von dem PFPE Überzug befreit, aus der Prozesskammer 40 entfernt und steht als Produkt 45b zur Verfügung. Anschließend wird eine neue Leiterplatte 45a in die Prozesskammer 40 gebracht und eine neue "Lötphase" mit recyceltem (wiederaufbereitetem) PFPE kann beginnen.

Nach dem Kondensieren in der Kondensationseinrichtung 90A erhält man also eine Mischung (Emulsion) aus ineinander nicht löslichen, flüssigen Komponenten (PFPE, Flussmittel, Lötpasten, etc.). Eventuell sind auch geringe Mengen Feststoffe alles Verunreinigungspartikel (beispielsweise Zinnpartikel) enthalten. In der vorliegenden Erfindung wird ein Tellerseparator 90B verwendet, um die flüssigen und festen Komponenten vom PFPE zu trennen. Ein Tellerseparator ist eine spezielle Art von Zentrifuge. Die einer Zentrifuge zugrunde liegende Idee basiert auf den Vorgängen in einem Absetztank. Dort sinken Partikel, Sedimente und Feststoffe langsam, der Schwerkraft folgend, zu Boden, und Flüssigkeiten unterschiedlicher Dichte trennen sich unter Einwirkung von Schwerkraft. Dieser Trennvorgang läuft jedoch sehr langsam ab. Ein Separator ist ein um eine Achse drehbarer Absetztank. Bei schneller Drehung der gesamten Einheit wird die Schwerkraft durch eine steuerbare Zentrifugalkraft ersetzt. Durch Einsetzen spezieller Teller wird die Oberfläche, auf der sich die verschiedenen Phasen absetzen können, vergrößert, was zu einer Beschleunigung des Trennvorgangs führt. Tellerseparatoren sind beispielsweise in der Milchindustrie bekannt, um den Rahm von der Milch zu trennen.

Optional (gestrichelt gezeichnet) kann das Kreislaufsystem der Reflow-Kondensationslötanlage eine Einrichtung 91, 91A aufweisen, mit der während der Lötphase gereinigtes und flüssiges PFPE zu der separierenden Kondensatfalle 90 zurückgeführt wird, so dass der Abkühlprozess der separierenden Kondensatfalle 90 beschleunigt und das PFPE besser gereinigt wird. Zu beachten ist, dass die Lötphase gleichzeitig die Abkühlphase der separierenden Kondensatfalle 90 ist. Weiterhin kann diese Einrichtung sowohl im intermittierenden Betrieb als auch im kontinuierlichen Betrieb benutzt werden. Im kontinuierlichen Betrieb dient diese Vorrichtung der Kühlung und der Aufrechterhaltung optimaler Trennbedingungen. Im intermittierenden Betrieb, also wenn der Separator zweitweise ruht, beispielsweise während einer Lötphase, kann die Vorrichtung zur Vorbefüllung des Separators verwendet werden, um reproduzierbarere Trennbedingungen zu schaffen.

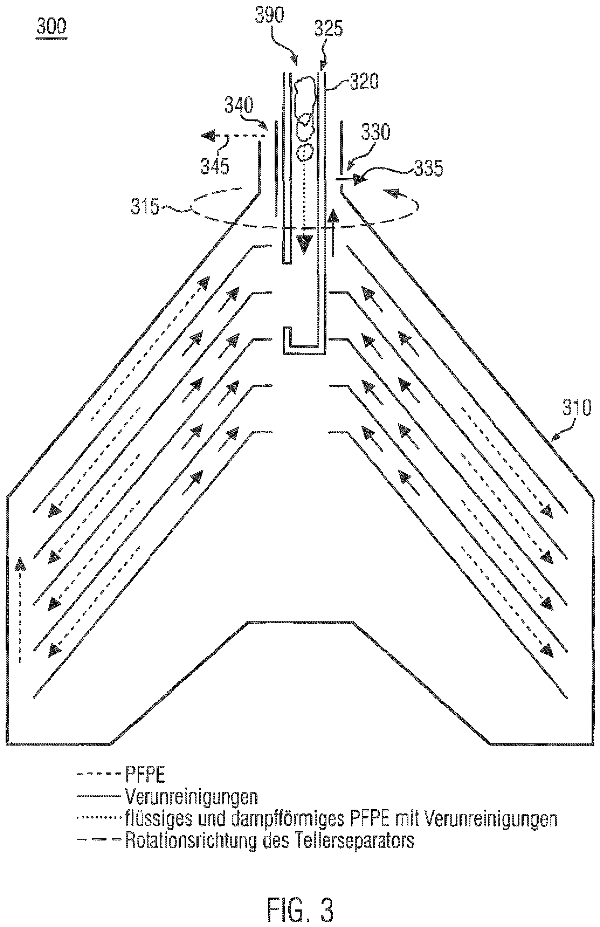

Figur 3 zeigt beispielhaft und schematisch einen Querschnitt eines Tellerseparators, wie er in der vorliegenden Erfindung verwendet wird. Figur 3 zeigt einen Tellerseparator 300 mit einer Trommel 310, einem Zulauf 320, einem ersten Ablauf 330, einen zweiten Ablauf 340 und einen Satz übereinander gestapelter Teller 370. Die Trennung in einem Tellerseparator erfolgt aufgrund von Dichteunterschieden, was dazu führt, dass im ersten Ablauf 330 die Flüssigkeit mit der relativ geringeren Dichte abgeführt werden kann und im zweiten Ablauf 340 die Flüssigkeit mit der relativ größeren Dichte abgeführt werden kann. Bei den derzeitigen Anwendungen und verwendeten Materialien weist das PFPE eine höhere Dichte als die Verunreinigungen auf, so dass in der Darstellung von Figur 3 der erste Ablauf 330 für die Verunreinigungen 335 und der zweiten Ablauf 340 für das gereinigte PFPE 345 vorgesehen sind. Die vorliegende Erfindung ist jedoch nicht auf dieses Beispiel beschränkt. Beispielsweise können in anderen Anwendungen Materialien verwendet werden, bei denen das PFPE eine geringere Dichte als die Verunreinigungen aufweist. In diesem Fall wäre der erste Ablauf 330 für das gereinigte PFPE und der zweite Ablauf 340 für die Verunreinigungen vorgesehen. Es wäre auch möglich, dass die Verunreinigungen teilweise eine geringere Dichte als das PFPE und teilweise eine größere Dichte als das PFPE und/oder zusätzliche Feststoffe aufweist. Mit entsprechend ausgelegten Tellerseparatoren lassen sich die Fraktionen der Flüssigkeitsphasen trennen. Beispielsweise kann im Tellerseparator ein Schlammraum vorgesehen sein, in dem sich die Feststoffe sammeln. Um mehr als zwei Flüssigphasen zu trennen, können beispielsweise mehrere Separatoren hintereinandergeschaltet werden. Besteht beispielsweise das kondensierte, nicht gereinigte Wärmeübertragungsmedium aus einer Phase geringer Dichte mit Verunreinigungen, einer PFPE Phase mit mittlerer Dichte und einer Phase hoher Dichte mit Verunreinigungen kann das gereinigte PFPE mit zwei hintereinander geschalteten Separatoren extrahiert werden.

In der in Figur 3 gezeigten Ausführungsform ist der Zulauf 320 mit einem Hohlraum versehen, durch den im Falle einer der Ausführungsart mit einer aktiven Kühlung eine Kühlflüssigkeit 325 fließen kann. Alternativ kann der Zulauf 320 auf jede geeignete Weise in Kontakt mit einer Vorrichtung stehen, die Wärme ableiten kann, beispielsweise einer Heatpipe oder fluidgekühlte Kühlkörper. Figur 3 soll jedoch nicht so verstanden werden, dass die vorliegende Erfindung auf aktive Kühlung beschränkt ist. Wie weiter unten ausführlicher beschrieben wird, kann anstelle des in Figur 3 gezeigten Hohlraums für das Kühlmittel 325 in alternativen Ausführungsformen der Zulauf massiv ausgestaltet sein, so dass dieser entsprechend eine hohe Wärmekapazität aufweist, um genügend Wärme aufnehmen und passiv kühlen zu können.

Das durch eine Pumpe aus der Prozesskammer abgepumpte Material 390 (flüssiges und dampfförmiges PFPE und Verunreinigungen) gelangt zum Zulauf 320 des Tellerseparators 300. Das dampfförmige PFPE kondensiert an den Wänden des gekühlten Zulaufs 320 und gelangt dann zusammen mit dem flüssigen PFPE und den Verunreinigungen in das Innere des Tellerseparators. Die Bestandteile trennen sich aufgrund der Zentrifugalkräfte verursacht durch die Rotation des Separators (unterbrochener Kreispfeil 315), so dass das schwere PFPE nach außen gedrängt wird (Pfeile 345) und die leichteren Verunreinigungen nach innen gedrängt werden (Pfeile 335). Über getrennte Abläufe 330 und 340 werden das gereinigte PFPE und die Verunreinigungen dann getrennt voneinander ausgeschieden.

In Figur 3 wird eine besonders vorteilhafte Ausführungsform einer separierenden Kondensatfalle für eine Reflow-Kondensationslötanlage gezeigt. Durch die Integration einer separierenden Kondensatfalle in den Kreislauf des Wärmeübertragungsmediums wird die Trennung des PFPEs und der Verunreinigungen beschleunigt. Der dabei verwendete Tellerseparator erfüllt eine doppelte Funktion: gasförmiges Wärmeübertragungsmedium kondensiert und im Kondensat enthaltene Verunreinigungen werden separiert. Die Kondensation des Wärmeübertragungsmediums wird mit einer Begrenzung der maximalen Temperatur der Bauteile des Separators (z.B. Einlass, Schwimmer, Teller, Trommel) erreicht. Die Begrenzung der Temperatur kann über eine aktive Kühlung und/oder durch eine hohe Masse der Teller, der Trommel, des Einlaufs und/oder anderer Komponenten gegenüber der Durchflussmenge erreicht werden. Die Separation der Verunreinigungen geschieht über zwei wesentliche Mechanismen. Zum einen ist die Kondensationstemperatur des PFPE höher als die der Verunreinigungen, so dass dieses zuerst kondensiert und das reine PFPE durch den Separator abfließt. Zum anderen wird der Dichteunterschied zwischen dem PFPE und den Verunreinigungen ausgenutzt, so dass eine Trennung der beiden Kondensate für Temperaturen unterhalb der Kondensationstemperatur der Verunreinigungen über die Zentrifugalkräfte stattfindet. Mittels dieser separierenden Kondensatfalle kann die Trennung des PFPEs und der Verunreinigungen beschleunigt werden. Somit kann das in der Anlage gebundene Wärmeübertragungsmedium schneller wieder dem Prozess zur Verfügung gestellt werden und eine Erhöhung des Anlagendurchsatzes wird ermöglicht.

Anzumerken ist, dass die Integration der Kondensation in den Tellerseparator besonders vorteilhaft ist, da durch die Kondensation bereits eine Vortrennung stattfindet, die dann durch die Tellerzentrifuge/Tellerseparator weiter verfeinert wird. Dadurch ist das Trennverfahren effizienter, d.h. genauer. Es ist jedoch auch eine räumliche Trennung zwischen Kondensation in einer speziellen Kondensationseinrichtung und Separation in einem Tellerseparator möglich.

Bei der passiven Kühlung kann die Tatsache genutzt werden, dass das Separieren/Trennen in einer Reflow-Kondensationslötanlage nicht kontinuierlich erfolgt, sondern während den Lötprozesszeiten ruht und in dieser Zeit abkühlen kann. Sind die Bauteile des Tellerseparators entsprechend den zu erwartenden Durchflussraten und Durchflusszeiten mit einer ausreichend großen thermischen Masse ausgestattet, die die Wärmeenergie beim Kondensieren während einer "Regenerationsphase" aufnehmen kann, und sind die Bauteile des Tellerseparators weiterhin so ausgestaltet, dass sie die vorher aufgenommene Wärmemenge während der "Lötphase" an die Umgebung abgeben können, ist weder eine vorgeschaltete Kondensationseinrichtung noch eine interne aktive Kühlung nötig.

Eine Unterstützung des Abkühlprozesses kann beispielsweise dadurch erfolgen, dass während der Lötphase, also der Phase, während der kein Dampf in den Separator eingeführt wird, kondensiertes und gereinigtes PFPE in den Tellerseparator eingeführt wird. Beispielsweise kann das während der Trennphase gereinigte Kondensat in der in Figur 2 mit dem Bezugszeichen 91 gekennzeichneten Einrichtung gesammelt werden, um es während der Lötphase dem in Figur 3 gezeigten Tellerseparator 300 über einen Rücklauf 91 A (nur in Figur 2 gezeigt) wieder zuzuführen. Dadurch wird zum einen dafür gesorgt, dass die hydrodynamischen Trennbedingungen immer gleichbleiben, da der Tellerseparator nicht leerläuft. Weiterhin wird durch Zuführen des kondensierten und gereinigten PFPE die in der Kondensationseinrichtung gespeicherte Wärme schneller abgeführt. Schlussendlich wird das kondensierte und gereinigte PFPE einer erneuten Separation unterzogen, so dass Wartungszyklen vergrößert werden können. Diese Unterstützung des Abkühlprozesses ist sowohl bei der passiven als auch bei der aktiven Kühlung möglich.

Eine andere Möglichkeit, einen kontinuierlichen Betrieb des Tellerseparators aufrecht zu erhalten wäre, im Tellerseparator kontinuierlich Dampf zuzuführen, beispielsweise von zwei oder mehreren getrennten Prozesskammern, die versetzt zueinander den Lötprozess und den Regenerationsprozess durchführen. Um in diesem Fall eines kontinuierlich betriebenen Tellerseparators mit integrierter Kondensationseinrichtung die Wärmeabfuhr zu gewährleisten, muss die Wärmeleitfähigkeit der wärmeabführenden Bauelemente ausreichend groß sein.

Beim Design des Tellerseparators können Anzahl, Form, Aufbau und Anordnung der Teller, das Volumen des Separators, die Geometrie des Zulaufs und die Drehgeschwindigkeit so ausgelegt werden, dass unter Berücksichtigung der Eigenschaften des verunreinigten Wärmeübertragungsmittels ein bestimmter Anlagendurchsatz mit einer bestimmten Reinigungsleistung erreicht werden kann. Beispielsweise kann in Abhängigkeit von Partikelgrößen und der Dichte der Partikel ein optimaler Tellerabstand gewählt werden, der im Bereich von 0,2 mm bis 14 mm liegt. Die Anzahl der Teller, die Drehgeschwindigkeit und das Volumen des Tellerseparators bestimmen die Trennleistung, d.h. wieviel Wärmeübertragungsmittel in einer bestimmten Zeiteinheit zu einem bestimmten Grad gereinigt wird. Typische Reflow Kondensationslötanlagen mit einem Kreislaufsystem für das Wärmeübertragungsmittel enthalten 20 - 40 Liter Wärmeübertragungsmittel, wovon in einem Lötprozess-Durchlauf 1 - 6 Liter verbraucht werden, die dann nach dem Lötprozess gereinigt werden müssen. Üblicherweise werden 4 - 250 Teller verwendet, die sich mit bis zu 30.000 Umdrehungen pro Minute drehen. Zur Verwendung in Reflow Kondensationslötanlagen mit einem Kreislaufsystem für das Wärmeübertragungsmittel werden bevorzugt mindestens 50 Teller verwendet, die sich mit mindestens 10.000 Umdrehungen pro Minute drehen. Der Einlauf wird vorteilhaft so konstruiert, dass im Einlauf eine Kondensation und eine damit einhergehende Vortrennung stattfindet.

## Patentansprüche

1. Reflow-Kondensationslötanlage (200) mit mindestens einer Prozesskammer (40) und einem Kreislaufsystem (210) für ein Wärmeübertragungsmedium, wobei das Kreislaufsystem eine Zentrifuge und eine Kondensationseinrichtung (90A) für das Wärmeübertragungsmedium umfasst.

2. Reflow-Kondensationslötanlage (200) nach Anspruch 1, wobei die Zentrifuge ein Tellerseparator (90B, 300) ist.

3. Reflow-Kondensationslötanlage (200) nach Anspruch 2, wobei der Tellerseparator (90B, 300) 4 bis 250 Teller umfasst, und/ oder
wobei der Tellerabstand im Bereich von 0,2 mm - 14 mm liegt.

4. Reflow-Kondensationslötanlage (200) nach Anspruch 3, wobei die Teller gleich beabstandet sind, oder
wobei der Tellerabstand im Zulaufbereich kleiner oder größer als am, dem Zulaufbereich gegenüberliegenden, Ende des Tellerstapels ist.

5. Reflow-Kondensationslötanlage (200) nach einem der Ansprüche 1 - 4, wobei die Zentrifuge ausgelegt ist, 1 - 150.000 Umdrehungen pro Minute auszuführen, vorzugsweise 1000 bis 10.000 Umdrehungen pro Minute, und/oder
wobei die Zentrifuge ausgelegt ist, 1 - 6 Liter kondensiertes Wärmeübertragungsmedium zu verarbeiten, und/oder
wobei die Kondensationseinrichtung (90A) für das Wärmeübertragungsmedium in der Zentrifuge (90B, 300) integriert ist.

6. Reflow-Kondensationslötanlage (200) nach Anspruch 5, wobei, wenn die Kondensationseinrichtung (90A) für das Wärmeübertragungsmedium in der Zentrifuge (90B, 300) integriert ist, die Kondensationseinrichtung (90A) für das Wärmeübertragungsmedium eine Einrichtung zur Begrenzung der Temperatur einer oder mehrerer Komponenten der Zentrifuge (90B, 300) umfasst.

7. Reflow-Kondensationslötanlage (200) nach Anspruch 6, wobei die Einrichtung zur Begrenzung der Temperatur eine aktive Kühlung der einen oder mehreren Komponenten der Zentrifuge (90B,300) umfasst, oder
wobei die Einrichtung zur Begrenzung der Temperatur eine passive Kühlung der einen oder mehreren Komponenten der Zentrifuge (90B,300) umfasst.

8. Reflow-Kondensationslötanlage (200) nach Anspruch 7, die bei passiver Kühlung weiterhin eine Einrichtung (91, 91A) aufweist, mit der gereinigtes PFPE während einer Abkühlphase der passiven Kühlung der Zentrifuge zugeführt werden kann.

9. Reflow-Kondensationslötanlage (200) nach einem der Ansprüche 7 - 8, wobei die Zentrifuge ein Tellerseparator ist und die eine oder mehreren Komponenten des Tellerseparators mindestens eines des Folgenden umfasst:
einen Einlass (320) des Tellerseparators (300), einen Schwimmer des Tellerseparators (300), einen oder mehrere Separatorenteller (370), eine Separatorentrommel (310).

10. Reflow-Kondensationslötanlage (200) nach einem der Ansprüche 7 und 9, wobei eine Wand der einen oder mehreren Komponenten mindestens einen Hohlraum (325) aufweist, durch den ein Kühlfluid strömen kann, oder
wobei in eine Wand der einen oder mehreren Komponenten eine Heatpipe integriert ist.

11. Reflow-Kondensationslötanlage (200) nach einem der Ansprüche 8 und 9, wobei mindestens eine Komponente der einen oder mehreren Komponenten so ausgestaltet ist, dass eine Wärmekapazität der mindestens einen Komponente ausreicht, eine Wärmemenge des vorbeiströmenden dampfförmigen Wärmeübertragungsmediums während einer vorbestimmten Trennphase aufzunehmen, so dass das Wärmeübertragungsmedium kondensiert.

12. Reflow-Kondensationslötanlage (200) nach einem der Ansprüche 1 - 11, wobei das Wärmeübertragungsmedium einen Siedepunkt von 260°C hat, und/oder wobei das Wärmeübertragungsmedium Galden ist.

13. Verfahren zum Betreiben der Reflow-Kondensationslötanlage (200) nach einem der Ansprüche 1 - 12, umfassend:
Einspritzen von dampfförmigen Perfluorpolyether in eine hermetisch dichte erste Prozesskammer (40) mit einer zu lötenden Baugruppe (45),
Erwärmen der Baugruppe (45) durch Kondensieren des dampfförmigen Perfluorpolyethers,
Absaugen von kondensierten und dampfförmigen Perfluorpolyether einschließlich Verunreinigungen,
Zuführen des abgesaugten Materials (390) an eine separierende Kondensatfalle (90), die einen Tellerseparator (90B, 300) und eine Kondensationseinrichtung (90A) zum Kondensieren des Perfluorpolyethers umfasst,
Kondensieren und Trennen des Perfluorpolyethers von den Verunreinigungen mit der separierenden Kondensatfalle (90), und
Verwenden des gereinigten Perfluorpolyethers (335) für einen Lötvorgang für eine nachfolgende Baugruppe (45A).

14. Verfahren nach Anspruch 13, bei dem der Tellerseparator (90B, 300) während einer Lötphase in einen Ruhezustand versetzt wird und bei dem der Tellerseparator (90B, 300) nach dem Ende der Ruhephase mit gereinigtem oder frischem Perfluorpolyether vorbefüllt wird, vorzugsweise mit 0,5 - 3 Liter Perfluorpolyether, und besonders bevorzugt mit 0,9 - 1,1 Liter Perfluorpolyether, oder
bei dem der Tellerseparator (90B, 300) kontinuierlich betrieben wird, wobei dem Tellerseparator (90B, 300) während einer Lötphase gereinigtes Perfluorpolyether (335) oder Dampf aus einer zweiten Prozesskammer, die zur ersten Prozesskammer zeitlich versetzt arbeitet, zugeführt wird.

## Claims

1. A reflow condensation soldering machine (200) comprising at least one process chamber (40) and a circulation system (210) for a heat transfer medium, wherein the circulation system comprises a centrifuge and a condensation device (90A) for the heat transfer medium.

2. The reflow condensation soldering machine (200) according to claim 1, wherein the centrifuge is a disc separator (90B, 300).

3. The reflow condensation soldering machine (200) according to claim 2, wherein the disc separator (90B, 300) comprises 4 to 250 discs, and/or
wherein the spacing between the discs is in the range of 0.2 mm - 14 mm.

4. The reflow condensation soldering machine (200) according to claim 5, wherein the discs are equally spaced, and/or
wherein the spacing between the discs in the inlet area is smaller or larger than at the end of the stack of discs opposite the inlet area.

5. The reflow condensation soldering machine (200) according to one of claims 1 - 4, wherein the centrifuge is adapted to perform 1 - 150,000 revolutions per minute, preferably 1,000 to 10,000 revolutions per minute, and/or
wherein the centrifuge is adapted to process 1 - 6 liters of condensed heat transfer medium, and/or
wherein the condensation device (90A) for the heat transfer medium is integrated in the centrifuge (90B, 300).

6. The reflow condensation soldering machine (200) according to claim 5, wherein, when the condensation device (90A) for the heat transfer medium is integrated in the centrifuge (90B, 300), the condensation device (90A) for the heat transfer medium comprises temperature limiting means of one or a plurality of components of the centrifuge (90B, 300).

7. The reflow condensation soldering machine (200) according to claim 6, wherein the temperature limiting means comprises active cooling of one or more components of the centrifuge (90B, 300), or
wherein the temperature limiting means comprises passive cooling of one or a plurality of components of the centrifuge (90B,300).

8. The reflow condensation soldering machine (200) according to claim 7, further comprising means (91, 91A) for supplying purified PFPE during a cooling phase of passive cooling of the centrifuge.

9. The reflow condensation soldering machine (200) according to one of claims 7 - 8, wherein the centrifuge is a disc separator and the one or a plurality of components of the disc separator comprises at least one of the following:
an inlet (320) of the disc separator (300), a float of the disc separator (300), one or a plurality of separator discs (370), a separator drum (310).

10. The reflow condensation soldering machine (200) according to one of claims 8 and 9, wherein a wall of said one or plurality of components comprises at least one cavity (325) through which a cooling fluid can flow, or
wherein a heat pipe is integrated in a wall of the one or plurality of components.

11. The reflow condensation soldering machine (200) according to one of claims 8 and 9, wherein at least one component of said one or plurality of components is configured such that a heat capacity of said at least one component is sufficient to absorb a quantity of heat of the vaporous heat transfer medium flowing past during a predetermined separation phase so that the heat transfer medium condenses.

12. The reflow condensation soldering machine (200) according to one of claims 1-18, wherein the heat transfer medium has a boiling point of 260°C, and/or
wherein the heat transfer medium is Galden.

13. A method of operating the reflow condensation soldering machine (200) according to one of claims 1-12, comprising:
injecting vaporous perfluoropolyethers into a hermetically sealed first process chamber (40) containing an assembly to be soldered (45),
heating the assembly (45) by condensing the vaporous perfluoropolyether,
suction of condensed and vaporous perfluoropolyethers including impurities,
feeding the extracted material (390) to a separating condensate trap (90) comprising a disc separator (90B, 300) and condensing device (90A) for condensing the perfluoropolyether,
condensing and separating the perfluoropolyether from the impurities with the separating condensate trap (90), and
using the purified perfluoropolyether (335) for a soldering process for a subsequent assembly (45A).

14. The method according to claim 21, in which the disc separator (90B, 300) is brought into a rest state during a soldering phase and in which the disc separator (90B, 300) is prefilled with purified or fresh perfluoropolyether after the end of the rest phase, preferably with 0.5 - 3 liters of perfluoropolyether, and particularly preferably with 0.9 - 1.1 liters of perfluoropolyether, or
in which the disc separator (90B, 300) is operated continuously, wherein purified perfluoropolyether (335) or vapor from a second process chamber, which operates with a time offset relative to the first process chamber, is fed to the disc separator (90B, 300) during a soldering phase.

## Revendications

1. Installation de brasage par refusion en phase vapeur (200) comprenant au moins une chambre de procédé (40) et un système de circuit (210) destiné à un milieu de transfert de chaleur, dans laquelle le système de circuit comprend une centrifugeuse et un dispositif de condensation (90A) destiné au milieu de transfert de chaleur.

2. Installation de brasage par refusion en phase vapeur (200) selon la revendication 1, dans laquelle la centrifugeuse est un séparateur à disques (90B, 300).

3. Installation de brasage par refusion en phase vapeur (200) selon la revendication 2, dans laquelle le séparateur à disques (90B, 300) comprend entre 4 et 250 disques, et/ou
dans laquelle la distance entre disques se situe dans la plage comprise entre 0,2 mm et 14 mm.

4. Installation de brasage par refusion en phase vapeur (200) selon la revendication 3, dans laquelle les disques sont équidistants, ou
dans laquelle la distance entre disques dans la région d'alimentation est inférieure ou supérieure à ce qu'elle est au niveau de l'extrémité, opposée à la zone d'alimentation, de l'empilement de disques.

5. Installation de brasage par refusion en phase vapeur (200) selon l'une quelconque des revendications 1 à 4, dans laquelle la centrifugeuse est conçue pour effectuer entre 1 et 150 000 tours par minute, de manière préférée entre 1 000 et 10 000 tours par minute, et/ou
dans laquelle la centrifugeuse est conçue pour traiter entre 1 et 6 litres de milieu de transfert de chaleur condensé, et/ou
dans laquelle le dispositif de condensation (90A) destiné au fluide caloporteur est intégré dans la centrifugeuse (90B, 300).

6. Installation de brasage par refusion en phase vapeur (200) selon la revendication 5, dans laquelle, lorsque le dispositif de condensation (90A) destiné au milieu de transfert de chaleur est intégré dans la centrifugeuse (90B, 300), le dispositif de condensation (90A) destiné au milieu de transfert de chaleur comprend un dispositif permettant de limiter la température d'un ou plusieurs composant(s) de la centrifugeuse (90B, 300).

7. Installation de brasage par refusion en phase vapeur (200) selon la revendication 6, dans laquelle le dispositif permettant de limiter la température comprend un refroidissement actif du ou des composant(s) de la centrifugeuse (90B, 300), ou
dans laquelle le dispositif permettant de limiter la température comprend un refroidissement passif du ou des composant(s) de la centrifugeuse (90B,300).

8. Installation de brasage par refusion en phase vapeur (200) selon la revendication 7, qui, dans le cas d'un refroidissement passif, présente en outre un dispositif (91, 91A) avec lequel du PFPE purifié peut être alimenté vers la centrifugeuse pendant une phase de refroidissement du refroidissement passif.

9. Installation de brasage par refusion en phase vapeur (200) selon l'une quelconque des revendications 7 à 8, dans laquelle la centrifugeuse est un séparateur à disques et le ou les composant(s) du séparateur à disques comprennent au moins un des éléments ci-dessous :
une entrée (320) du séparateur à disques (300), un flotteur du séparateur à disques (300), un ou plusieurs disque(s) de séparateur (370), un tambour de séparateur (310).

10. Installation de brasage par refusion en phase vapeur (200) selon l'une quelconque des revendications 7 et 9, dans laquelle une paroi du ou des composant(s) présente au moins une cavité (325) à travers laquelle un fluide de refroidissement peut circuler, ou
dans laquelle un caloduc est intégré dans une paroi du ou des composants.

11. Installation de brasage par refusion en phase vapeur (200) selon l'une quelconque des revendications 8 et 9, dans laquelle au moins un composant parmi le ou les composant(s) est conçu de sorte qu'une capacité thermique du au moins un composant est suffisante pour absorber pendant une phase de séparation prédéterminée une quantité de chaleur du milieu de transfert de chaleur en phase vapeur en cours de circulation, de sorte que le milieu de transfert de chaleur condense.

12. Installation de brasage par refusion en phase vapeur (200) selon l'une quelconque des revendications 1 à 11, dans laquelle le milieu de transfert de chaleur présente un point d'ébullition de 260°C, et/ou
dans laquelle le milieu de transfert de chaleur est un fluide Galden^{®}.

13. Procédé de fonctionnement de l'installation de brasage par refusion en phase vapeur (200) selon l'une quelconque des revendications 1 à 12, comprenant les étapes consistant à :
injecter du perfluoropolyéther en phase vapeur dans une première chambre de procédé (40) hermétiquement étanche contenant un ensemble à souder (45),
chauffer l'ensemble (45) par condensation du perfluoropolyéther en phase vapeur,
aspirer le perfluoropolyéther condensé et le perfluoropolyéther en phase vapeur, y compris les impuretés,
alimenter le matériau aspiré (390) vers un piège à condensat séparateur (90), qui comprend un séparateur à disques (90B, 300) et un dispositif de condensation (90A) permettant de condenser le perfluoropolyéther,
condenser et séparer le perfluoropolyéther et les impuretés grâce au piège à condensat séparateur (90) , et
utiliser le perfluoropolyéther (335) purifié pour une opération de brasage destinée à un ensemble (45A) ultérieur.

14. Procédé selon la revendication 13, dans lequel le séparateur à disques (90B, 300) est placé dans un état de repos pendant une phase de brasage et dans lequel le séparateur à disques (90B, 300) est prérempli après la fin de la phase de repos avec du perfluoropolyéther purifié ou frais, de manière préférée avec entre 0,5 et 3 litres de perfluoropolyéther, et de manière particulièrement préférée avec entre 0,9 et 1,1 litre de perfluoropolyéther, ou
dans lequel le séparateur à disques (90B, 300) fonctionne en continu, dans lequel du perfluoropolyéther (335) purifié ou une phase vapeur issue d'une seconde chambre de procédé fonctionnant en décalage temporel par rapport à la première chambre de procédé est alimenté(e) vers le séparateur à disques (90B, 300) pendant une phase de brasage.
